# EUROPEAN PATENT APPLICATION

(11) **EP 2 562 807 A1**
(43) Date of publication of application: **27.02.2013**
(21) Application number: 11178270.2
(22) Date of filing: 22.08.2011
(51) Int. Cl.: H01L 23/373

(54) **Heat transfer in an electronic device**

(71) Applicant: ABB Research Ltd, 8050 Zürich (CH)
(72) Inventor: Velthuis, Rudi, 79787 Lauchringen (DE); Ecklebe, Andreas, 8983 Dietikon (CH); Agostini, Francesco, 4800 Zofingen (CH)
(74) Representative: Tiilikainen, Jarkko Tapio

(57) **Abstract**

Heat transfer in an electronic device by means of a heat transfer element (2) and the method of preparing such a device. The electronic device comprises at least one heat dissipating component (1) and the heat transfer element (2) has a connection area (3) connected to said at least one heat dissipating component (1). The heat transfer element (2) also has at least one heat dissipating area (4) and including a thermal path from the connection area (3) to the at least one heat dissipating area (4). The heat transfer element (2) further includes carbon fibers (5) arranged along the thermal path. According to an embodiment, the carbon fibers (5) are pitch based carbon fibers and are embedded in a resin. Then, the heat transfer element (2) can provide greater thermal conductivity in the direction (6) along the thermal path compared to the direction perpendicular to the thermal path.

## Description

### Technical Field

The present invention relates to heat transfer mechanisms in electronic devices and in particular to an electronic device that comprises at least one heat dissipating component and a heat transfer element connected to the heat dissipating component.

Such devices are in particular devices that include power electronic components. One particular example is a frequency converter.

### Background Art

Thermal management and specifically cooling of electronic devices is a major topic for a safe, reliable and efficient component operation. There is a challenge of proposing thermal solutions that are able to answer to constant increase in the power density at component level and at device level.

The cooling mode of devices can be classified generically as: convection, radiation, conduction. Additionally, convection can be reached by single phase or two-phase flow.

The cooling arrangements typically use fluids and fluid flows or solid materials that have a sufficiently high thermal conductivity. The most common examples of such solid materials are aluminum and copper. The reason for using aluminum and copper is that the material needs to have good thermally conductive properties and at the same time good mechanical properties for mechanical stability and reliable operation of the device. For thermal management any material with good mechanical properties, high thermal conductivity and sometimes also low density would be suitable for thermal management.

Also composite materials have been suggested for thermal conduction. US 7 651 767 B2 and US 2009/0061193 A1 disclose the use of carbon fiber reinforcement for improving thermal conductivity of a resin molded product. Carbon fiber reinforced plastic is also suggested in US 6 259 602 B1 even though the document mainly suggests to use aluminum, copper or silver. In this document, thermal conduction is performed by a heat conductive device that has rigid regions and bendable regions.

WO 2011/037578 A1 discloses a further heat transfer apparatus. The heat transfer apparatus includes a thermal conduit that can be disposed at least partially within an electronic device enclosure. A non-heat conductive material can be disposed at least partially about at least a portion of the thermal conduit. The thermal conduit can be a material having a high thermal conductivity, for example aluminum, aluminum alloy, a copper or copper alloy. The non-heat conductive material can include asbestos, carbon fiber, silica, diatomaceous earth, cork, wool, cotton, plastics, fiberglass, mineral wool, polystyrene, combinations thereof, and the like.

### Disclosure of Invention

It is an object of the present invention to provide an electronic device with a new heat transfer element that has sufficiently good properties at least in view of thermal conductivity.

Other desired properties that could be optionally achieved are e.g. suitable mechanical strength, suitable price, relatively light weight and capability to manufacture in desired shapes. Also capability to conduct heat directionally as in the above-cited WO 2011/037578 A1 would be useful property.

The object of the invention is achieved by providing the heat transfer element with carbon fibers that are arranged along the desired thermal path. This provides a good thermal conductivity in the desired direction and relatively lower conductivity in the direction perpendicular to the thermal path.

### Brief Description of Drawings

For a more complete understanding of the present invention and the advantages thereof, the invention is now described with the aid of the examples and with reference to the following drawings, in which:
Figure 1 presents an electronic device and a heat transfer element according to an embodiment;
Figure 2 presents an electronic device and a heat transfer element according to another embodiment;
Figure 3 presents an electronic device and a heat transfer element according to a further embodiment;
Figure 4 presents an even further embodiment of an electronic device and a heat transfer element;
Figure 5 presents a still further embodiment of an electronic device and a heat transfer element;
Figure 6 presents an embodiment wherein a device case is made of material comparable to that of the heat transfer element;
Figure 7 presents an embodiment having a curved heat transfer element; and
Figure 8 presents an embodiment wherein the heat transfer element has a layer structure of different kinds of carbon fibers.

### Modes for Carrying Out the Invention

As described above, the invention is based on providing the heat transfer element with carbon fibers that are arranged along the desired thermal path. This has the effect that the longitudinal direction of the fibers is substantially parallel to the direction of the thermal path. Thus, when the carbon fibers are arranged along the thermal path, the carbon fibers are not randomly distributed as in the prior art but are substantially parallel to each other. This has the effect that in the direction of the thermal path, the thermal conductivity is facilitated by the relatively high thermal conductivity of the carbon fibers whereas in the transverse direction, the thermal conductivity is lower because of the gaps and interfaces between the parallel carbon fibers. This arrangement provides a good thermal conductivity in the desired direction and relatively lower conductivity in the direction perpendicular to the thermal path.

Carbon fibers exhibit high thermal conductivity up to 1100 [W/mK], for instance. High alignment in the fibers indicates that perpendicularly to the fibers themselves, the thermal conductivity is much lower and can range between 3 and 10 [W/mK], for instance. According to an embodiment, the carbon fibers are embedded in a resin during the process of generation of a suitable geometry of the heat transfer element.

According to an embodiment, a composite structure with a resin type EX1515 is provided and then the thermal conductivity perpendicularly to the fiber direction is 1.2 [W/mK] and 360 [W/mK] in the fiber direction.

Usually, the thermal conductivity of the heat transfer element is more than 100 [W/mK] in the fiber direction, i.e. in the direction of the thermal path. The thermal conductivity along the thermal path can range between 200 and 1 000 [W/mK], for instance.

The thermal conductivity of the heat transfer element perpendicularly to the fiber direction is usually less than 50 [W/mK], such as less than 10 [W/mK], and in advantageous embodiments less than 2 [W/mK], for instance.

Thus, it is possible to produce heat transfer elements that exhibit directional heat transfer such that thermal conductivity is for example 10 times higher in the direction of the desired thermal path than in the direction perpendicular to the thermal path. This factor can also be higher, such as 100 or 250 or even 400. In the above-referred example using resin type EX1515, the factor is 300.

Properties depend from the material grade and usually the price of the material is proportional to the quality of the grade. Usually, a lower thermal conductivity goes together with a lower price and higher thermal conductivity grades are more expensive.

**Table 1 shows one example of a fiber and a resin.**

| **Material ID** | **Thermal conductivity λ_{0°} [W/mK]** | **Thermal conductivity λ_{90°} [W/mK]** |
|---|---|---|
| K13C | 600 | - |
| K13C/EX1515 | 360 | 1.2 |

Table 1: Thermal conductivity of fiber type K13C (Mitsubishi Chemical America) as a fiber and in composite with resin EX1515 (TENCATE ADVANCED COMPOSITES USA, INC.).

More information relating to the fibers can be found in publication by Ozakim T; Naito, K; Mikami, I; Yamauchi, H; Tsuneta, S.: 51th High precision Composite Pipers for Solar-B Optical Structures. International Astronautical Congress, Rio de Janeiro, October 2000, which publication is incorporated herein by reference. Further information is provided also by the above-referred background art documents US 7 651 767 B2 and US 2009/0061193 A1, which are also incorporated herein by reference.

As is disclosed in the above-referred Ozakim et al. publication, pitch based carbon fibers are used for aeronautics applications, not only for their thermal properties but also due to the low coefficient of thermal expansion and the ultra high stiffness of the fibers. Also the light weight and ultra-high stiffness of the fibers could be useful in some applications, for example when the heat transfer elements are incorporated in fast moving parts, like in robotics.

Pitch based carbon fibers are also used in compression molding compounds to make more complex structures, like it could be required for housings. Compared to woven fabric or unidirectional fibers, molding compounds have shorter fiber length and the fibers are after compression molding more random in the component. The in-plane thermal conductivity is therefore reduced, but the compounds can make complex structures.

More detailed information about the manufacturing of carbon fibers can be found in the book Morgan, P.: Carbon Fibers and Their Composites, Marcel Dekker Inc, 2005, which is incorporated herein by reference.

According to embodiments of our invention, peculiar characteristics of the pitch based carbon fibers, i.e. the difference in thermal conductivity in perpendicular directions, is used advantageously for specific applications where the heat should follow a certain path and direction. Such embodiments can effectively target the heat transport in one direction and avoiding it in the other.

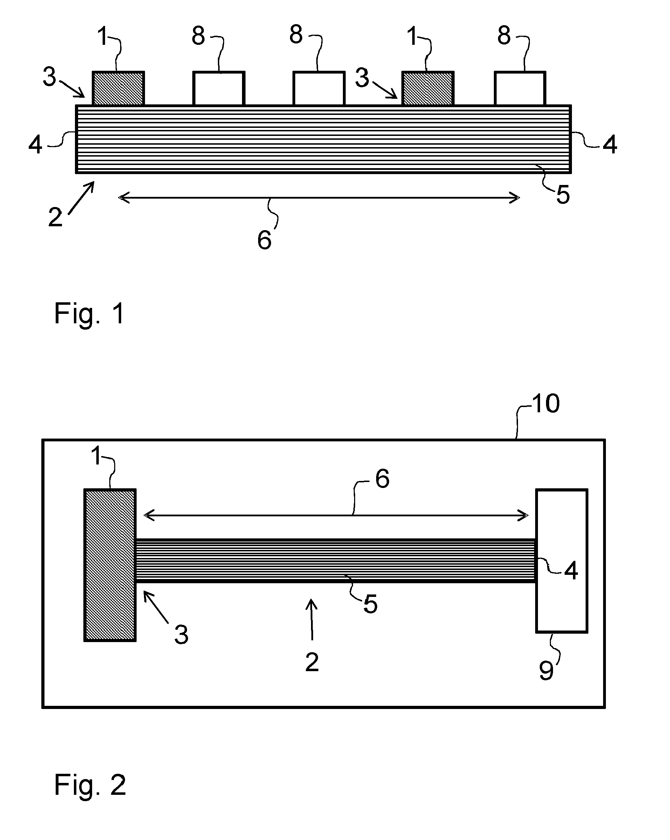

Fig. 1 shows an embodiment, comprising two heat dissipating components 1, i.e. components that dissipate so much heat during their operation that there is need to facilitate heat transfer away from the components. The heat dissipating components 1 are mounted on the surface of a heat transfer element 2, which includes parallel carbon fibers 5 embedded in a resin. Fig. 1 shows also connection areas 3 that are the areas on which the heat dissipating components 1 are mounted. The heat transfer element 2 has also heat dissipating areas 4 at both of its ends. A thermal path of relatively high thermal conductivity is created between the connection areas 3 and the heat dissipating areas 4 by means of the carbon fibers 5 that are generally aligned along the direction from the connection areas 3 to the heat dissipating areas 4. The direction 6 along the thermal path is also indicated in Fig. 1 by means of an arrow. In the embodiment of Fig. 1, there are also "cold" components 8, i.e. components that do not dissipate so much heat, mounted on the surface of the heat transfer element 2.

Fig. 2 discloses an embodiment, wherein the heat dissipating component 1 and the heat transfer element 2 are enclosed within a device case 10 and the heat dissipating area 4 of the heat transfer element 2 is connected to a cold element 9 for transferring heat from the heat dissipating component 1 to the cold element 9 via the carbon fibers 5 of the heat transfer element 2.

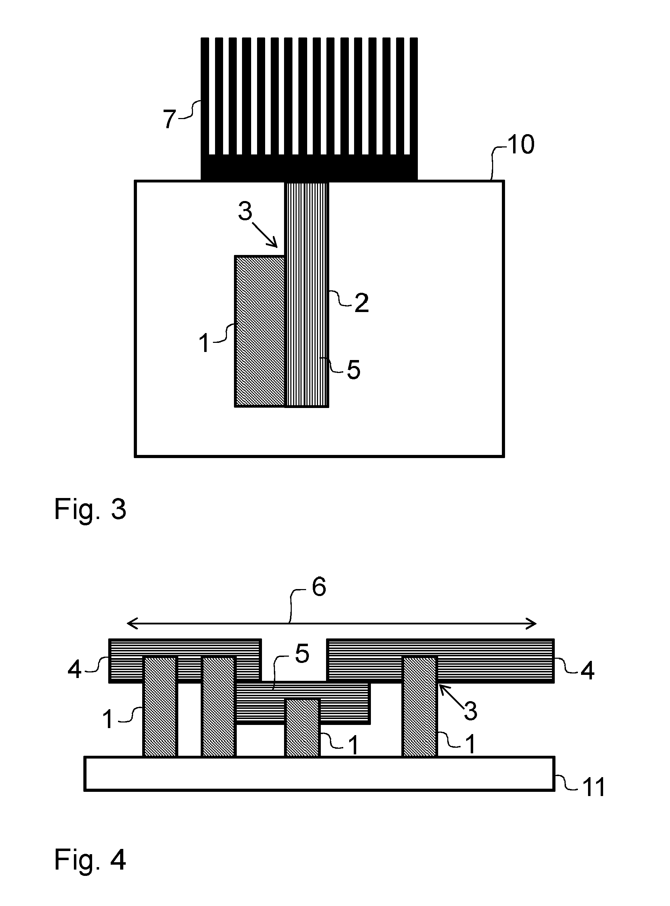

Fig. 3 discloses an embodiment, wherein the heat dissipating component 1 and the heat transfer element 2 are enclosed within a device case 10 and the heat dissipating area 4 of the heat transfer element 2 is connected to a heat sink 7 outside the device case 10. Then, heat is transferred from the heat dissipating component 1 to the heat sink 7 via the carbon fibers 5 of the heat transfer element 2 and will be dissipated outside the device case 10. According to an embodiment, also the heat sink 7 comprises carbon fibers. In a further embodiment, the heat sink 7 and the heat transfer element 2 are made in a single piece integral heat dissipation part. However, any suitable heat sink 7 can be used in the embodiments.

Fig. 4 discloses an embodiment, wherein the heat dissipating components 1 are mounted on a circuit board 11 and the heat transfer element 2 is placed on top of the components is a way that conforms to the shapes of the upper parts of the heat dissipating components 1. This also means that the connection areas 3 can protrude inside the heat transfer element 2. The direction 6 of the thermal path is substantially parallel to the width of the circuit board 11.

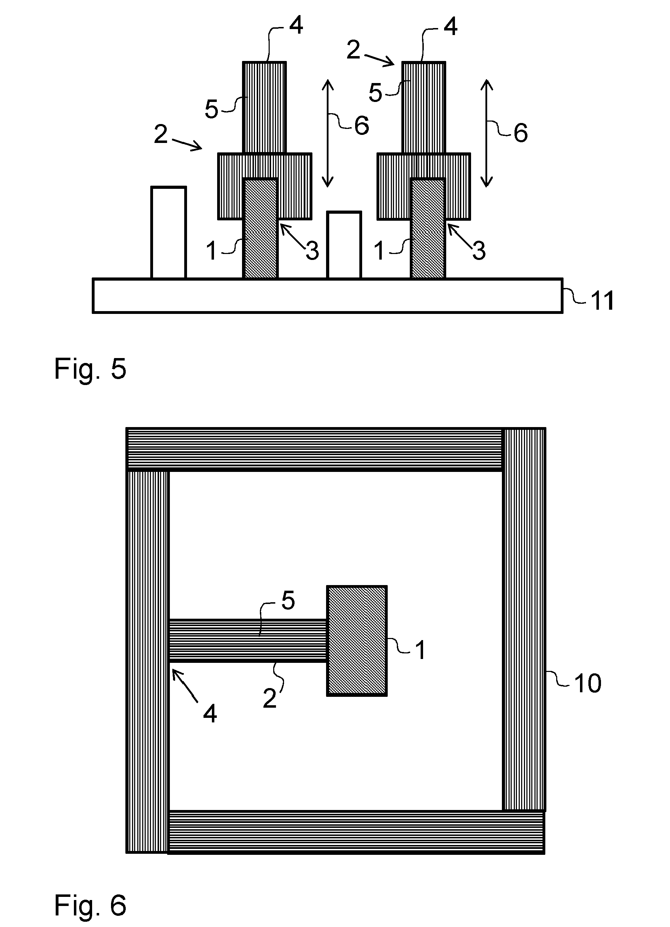

Fig. 5 discloses an embodiment, wherein the heat dissipating components 1 are mounted on a circuit board 11 and individual heat transfer elements 2 are placed on top of the heat dissipating components 1. Also in this embodiment it is possible - but not necessarily a requirement - that the heat transfer elements 2 conform to the shapes of the upper parts of the heat dissipating components 1. In this embodiment, the directions 6 of the thermal paths are substantially perpendicular to the width of the circuit board 11.

Fig. 6 discloses an embodiment, wherein the heat dissipating component 1 and the heat transfer element 2 are enclosed within a device case 10 that has been made from a similar material than the heat transfer element 2. In one possible embodiment, the device case 10 is a single piece part including bended carbon fibers. However, any suitable structure can be used.

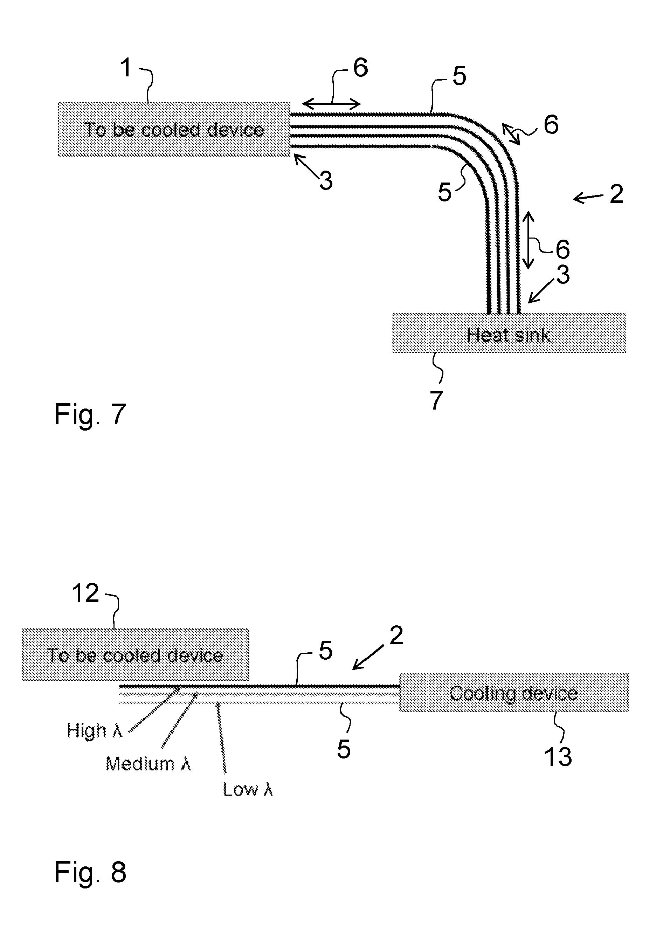

Fig. 7 discloses an embodiment, wherein the heat transfer element 2 is curved between the heat dissipating component 1 and the heat sink 7. Then, the carbon fibers 5 have been bended during the manufacture.

Fig. 8 discloses an embodiment, wherein the heat transfer element 2 has been connected between a device 12 to be cooled and a cooling device 13. The heat transfer element 2 has been constructed as a layer structure having a plurality of layers of different grades of carbon fibers 5. Then, the layer adjacent to the connection area 3 can be made of more expensive carbon fibers 5 having a higher thermal conductivity and the lower layers placed on top of the first layer can be made of cheaper carbon fibers 5 that are not as effective in transferring heat. This can make the heat transfer element 2 more economical without substantially decreasing the capability to transfer heat. This is because the lower layers need not always be as effective in heat transfer as the first layer because of a temperature gradient between the layers.

According to an embodiment, the above-described or a corresponding layer structure is made as an integral part of a printed circuit board. It is also possible to provide printed circuit boards with other kinds of heat transfer elements 2. In such embodiments, the carbon fibers 5 can also be embedded inside the circuit board substrate when manufacturing the substrate laminate.

The use of pitch based carbon fibers in embodiments will increase in-plane thermal conduction of the material with an increased flexibility toward shape and geometry, because the fibers can be shaped as desired.

Some embodiments enable hot spot "management" by spreading the heat over a wide area and limiting the over temperature of electric components possibly connected to the support material.

There are also embodiments that enable interconnection, by means of shaped carbon fibers, of hot and cold spots within the device. When the shaped carbon fibers connect different parts of the devices that have different temperatures, more uniform temperature is attained and therefore thermal gradients remain smaller. One of the advantages compared to common thermal conductors is in the possibility of shaping the thermal conductor in almost any shape. The device itself may be a drive, a switch, a circuit breaker or any possible electric component that has a necessity of reducing the thermal gradients in the device by connecting spots at different locations.

There are also embodiments that increase the heat transfer by conduction, collecting and driving the heat from the point where it is generated out from the device. According to some embodiments, the carbon fibers 5 can be shaped for bringing the heat from the generating point to a common heat sink installed outside of the device. This may be of interest for cabinet cooling in case high IP may be required. Then, the pitch based carbon fibers may act as a "heat bus".

It is also possible to build up a device case of a carbon fiber material. This gives a good mechanical resistance and the "sensible components" can be directly connected over to the case that spreads the heat. In some high IP configurations, the device case plays a dominant role in the heat dissipation. In some embodiments the device case can be substituted by a carbon fiber structure and the specific elements that need to be cooled can be attached directly or indirectly to it.

It is also possible to overmold passive or active components by resin and properly shaped carbon fibers to conduct the heat to places where the heat can be easily dissipated.

It is also possible to configure pluggable carbon fiber elements and attach these over active or passive components.

Some embodiments suggest building up part of the power module from a resin carbon fiber composition (oriented carbon fibers) to increase the thermal spreading. In these embodiments, also the characteristic of the pitch carbon fiber material in terms of coefficient of thermal expansion (CTE) may be of great interest.

According to embodiments, the thermal conductivity in the out of plane direction is much lower than in fiber direction such that the surroundings of the cooling structures are not heated as much as when using isotropic metallic cooling structures.

According to embodiments of manufacturing methods, the carbon fibers can be bended and then embedded in resin and the resin cured, so that the geometry can be designed in such a way that the direction of high thermal conductivity can be selected according to the need of the application. The resin itself can be thermoset or thermoplastic.

In some embodiments, the carbon fibers are insulated so that the heat transfer element can withstand some electrical field in thickness direction.

According to an embodiment, there is provided an electronic device comprising at least one heat dissipating component 1 and a heat transfer element 2. The heat transfer element 2 has a connection area 3 connected to the at least one heat dissipating component 1 and also at least one heat dissipating area 4. The heat transfer element 2 including a thermal path from the connection area 3 to the at least one heat dissipating area 4 and further includes carbon fibers 5 arranged along the thermal path.

In a further embodiment, at least a portion of the carbon fibers 5 are pitch based carbon fibers. In a further embodiment, all or substantially all of the carbon fibers 5 are pitch based carbon fibers.

In a further embodiment, at least some of the carbon fibers 5 extend the entire distance from the connection area 3 to the at least one heat dissipating area 4. It is also possible that all or substantially all of the carbon fibers 5 extend the entire distance from the connection area 3 to the at least one heat dissipating area 4. However, the price of the heat transfer element 2 may sometimes be reduced by using at least some shorter fibers in addition to the longer fibers. It is also possible that the heat transfer element 2 does not have any fibers that extend the entire distance from the connection area 3 to the at least one heat dissipating area 4 but each of the fibers 5 extends only a portion of the distance from the connection area 3 to the at least one heat dissipating area 4. When the lengths of such shorter fibers overlap, heat is still effectively transferred from the connection area 3 to the at least one heat dissipating area 4.

In a further embodiment, substantially all of the carbon fibers 5 are substantially parallel to the thermal path. At least for some applications, substantially all of the carbon fibers are parallel when for example 90 % of the total length of the carbon fibers 5 is substantially parallel to the thermal path.

In a further embodiment, the thermal path is curved and the heat transfer element 2 includes bended carbon fibers.

In a further embodiment, the carbon fibers 5 of the heat transfer element 2 are embedded in resin.

In a further embodiment, the thermal conductivity of the resin is substantially lower than the thermal conductivity in the longitudinal direction of each of the carbon fibers 5. When the carbon fibers 5 are also substantially parallel with the thermal path, the thermal conductivity of the heat transfer element 2 is substantially greater in the direction 6 along the thermal path compared to the direction perpendicular to the thermal path.

In a further embodiment, the heat transfer element 2 comprises a first layer of carbon fibers of a first grade and at least one second layer of carbon fibers of at least one second grade.

In a further embodiment, the at least one heat dissipating area 4 is connected to a heat sink 7.

According to an embodiment, there is also provided a method of equipping an electronic device with a heat transfer element 2. Such an electronic device can have at least one heat dissipating component 1 and the heat transfer element 2 has at least one heat dissipating area 4. The method comprises connecting a connection area 3 of the heat transfer element 2 to the at least one heat dissipating component 1 such that the heat transfer element 2 creates a thermal path between the at least one heat dissipating component 1 and the at least one heat dissipating area 4. Furthermore, the method of making the heat transfer element 2 comprises arranging carbon fibers 5 along the thermal path.

In a further embodiment, the method comprises using pitch based carbon fibers as the carbon fibers.

In a further embodiment, the method comprises aligning the carbon fibers 5 with the thermal path.

In a further embodiment, the method comprises casting resin over a plurality of parallel carbon fibers 5 to form the heat transfer element 2 such that the plurality of parallel carbon fibers 5 are at least partially within the resin.

In a further embodiment, the method comprises bending a plurality of parallel carbon fibers (5) in a desired shape and casting resin over the bended carbon fibers 5 to form the heat transfer element 2 such that the plurality of parallel carbon fibers 5 are in the desired shape and at least partially within the resin.

In a further embodiment, the method comprises arranging first carbon fibers of a first grade as a first layer and second carbon fibers of a second grade as at least one second layer on top of the first layer.

Embodiments provide high thermal conductivity that will enable transfer of the heat from the device to be cooled to the cooler with a low thermal resistance.

As there are several of grades of pitch based carbon fibers, a composite lay-out can also be made. Then, it is preferable that the side in contact with the "to be cooled device" has the highest thermal conductivity to extract the heat. Other parts of the composite structure can have lower grade fibers.

Embodiments provide improved thermal management and therefore enable a higher power density. The pitch based carbon fiber cooling structure itself does heat up the surrounding much less than aluminum or copper, for instance. Less air cooling is required as the surrounding temperature is decreased.

Another possible advantage of some of the embodiments is increased geometrical freedom as the carbon fibers can be bended and have a high thermal conductivity only in fiber direction. Final mounting of the cooling section to a heat sink can be made on a location where it can be afforded.

Thus, embodiments may provide competitive advantages due to the increased power density and therefore also smaller components and devices can be made.

Embodiments may also provide improved cooling and therefore increase the component reliability and help in achieving slower thermal ageing.

The above description is only to exemplify the invention and is not intended to limit the scope of protection offered by the claims. The claims are also intended to cover the equivalents thereof and not to be construed literally.

### List of reference numbers

heat dissipating component 1
heat transfer element 2
connection area 3
heat dissipating area 4
carbon fibers 5
the direction 6 along the thermal path
heat sink 7
"cold" component 8
cold element 9
device case 10
circuit board 11
device to be cooled 12
cooling device 13.

### List of references cited in the specification

US 7 651 767 B2
US 2009/0061193 A1
US 6 259 602 B1
WO 2011/037578 A1
Ozakim T; Naito, K; Mikami, I; Yamauchi, H; Tsuneta, S.: 51th High precision Composite Pipers for Solar-B Optical Structures. International Astronautical Congress, Rio de Janeiro, October 2000
Morgan, P.: Carbon Fibers and Their Composites, Marcel Dekker Inc, 2005, ISBN 0-8247-0983-7.

## Claims

1. An electronic device comprising: at least one heat dissipating component (1); and a heat transfer element (2), said heat transfer element (2) having a connection area (3) connected to said at least one heat dissipating component (1) and at least one heat dissipating area (4), the heat transfer element (2) including a thermal path from the connection area (3) to the at least one heat dissipating area (4), **characterized in that** the heat transfer element (2) further includes carbon fibers (5) arranged along the thermal path.

2. The electronic device of claim 1, wherein at least a portion of the carbon fibers (5) are pitch based carbon fibers.

3. The electronic device of claim 1 or 2, wherein at least some of the carbon fibers (5) extend the entire distance from the connection area (3) to the at least one heat dissipating area (4).

4. The electronic device of any one of claims 1 to 3, wherein substantially all of the carbon fibers (5) are substantially parallel to the thermal path.

5. The electronic device of any one of claims 1 to 4, wherein the thermal path is curved and the heat transfer element (2) includes bended carbon fibers.

6. The electronic device of any one of claims 1 to 5, wherein the carbon fibers (5) of the heat transfer element (2) are embedded in resin.

7. The electronic device of claim 6, wherein
the thermal conductivity of the resin is substantially lower than the thermal conductivity in the longitudinal direction of each of the carbon fibers (5); and
the carbon fibers (5) are substantially parallel with the thermal path,
whereby the thermal conductivity of the heat transfer element (2) is substantially greater in the direction (6) along the thermal path compared to the direction perpendicular to the thermal path.

8. The electronic device of any one of claims 1 to 7, comprising a first layer of carbon fibers of a first grade and at least one second layer of carbon fibers of at least one second grade.

9. The electronic device of any one of claims 1 to 8, wherein the at least one heat dissipating area (4) is connected to a heat sink (7).

10. A method of providing an electronic device with a heat transfer element (2), wherein the electronic device has at least one heat dissipating component (1) and the heat transfer element (2) has at least one heat dissipating area (4), said method comprising connecting a connection area (3) of the heat transfer element (2) to said at least one heat dissipating component (1) such that the heat transfer element (2) creates a thermal path between the at least one heat dissipating component (1) and the at least one heat dissipating area (4), **characterized by** arranging carbon fibers (5) along the thermal path.

11. The method of claim 10, further comprising using pitch based carbon fibers as the carbon fibers.

12. The method of claim 10 or 11, further comprising aligning the carbon fibers (5) with the thermal path.

13. The method of any one of claims 10 to 12, further comprising
contacting a plurality of parallel carbon fibers (5) with resin to form the heat transfer element (2), wherein the plurality of parallel carbon fibers (5) are at least partially within the resin.

14. The method of any one of claims 10 to 12, further comprising bending a plurality of parallel carbon fibers (5) in a desired shape; and
contacting the bended carbon fibers (5) with resin to form the heat transfer element (2), wherein the plurality of parallel carbon fibers (5) are in the desired shape and at least partially within the resin.

15. The method of any one of claims 10 to 14, comprising
arranging first carbon fibers of a first grade as a first layer; and
arranging second carbon fibers of a second grade as a second layer on top of the first layer.
